(19) Europäisches Patentamt
European Patent Office
Office européen des brevets

(11) **EP 2 521 158 A1**

(12) **EUROPEAN PATENT APPLICATION**

(43) Date of publication:
**07.11.2012 Bulletin 2012/45**

(51) Int Cl.:
*H01J 37/32* (2006.01)  *G01R 19/00* (2006.01)
*H05H 1/00* (2006.01)

(21) Application number: **12166974.1**

(22) Date of filing: **07.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.05.2011 US 201161482980 P**

(71) Applicant: **IMEC**
**3001 Leuven (BE)**

(72) Inventors:
• **Samara, Vladimir**
**3001 Leuven (BE)**
• **De Marneffe, Jean-Francois**
**3001 Leuven (BE)**
• **Boullart, Werner**
**3001 Leuven (BE)**

(74) Representative: **Sarlet, Steven Renaat Irène et al**
**Gevers Patents**
**Holidaystraat 5**
**1831 Diegem (BE)**

(54) **Plasma probe and method for plasma diagnostics**

(57)    Device and method for monitoring a plasma in a chamber of a plasma reactor, comprising measuring plasma parameter data at a surface of a single planar Langmuir probe in contact with the plasma. A biasing capacitor is connected between the single planar Langmuir probe and a DC-bias source. Subsequently a discharge current of the biasing capacitor as a result of the DC-bias is measured, and a probe potential at the single probe during the discharge. The measurements can be used to detect presence and/or thickness of a dielectric film on the probe surface.

**Figure 1**

EP 2 521 158 A1

**Description**

**Technical field**

The present disclosure relates to a plasma diagnosis device and method. More specifically it relates to a DC pulsed Langmuir probe suitable to be used for plasma diagnostics in a semiconductor manufacturing tool. Plasma diagnostics is the monitoring of plasma parameter data, such as positive ions flux and/or electron flux.

**Background art**

In industrial plasma processing it would be useful to directly control plasma properties like plasma potential, density, ion flux etc. Unfortunately, conventional probes used in research often do not comply with industrial processes or are too complex for routine exploitation.

The Langmuir probe is one of the most important techniques in plasma diagnostics, but its implementation into industrial plasma chambers is difficult for two main reasons: unwanted perturbation and contamination of the plasma and limitation of the technique because of deposits on the probe.

US5936413 discloses a capacitively coupled planar Langmuir probe that can be used for plasma monitoring. The known probe monitors the ion flux arriving to the probe which is determined from the discharging of an RF-biased capacitance in series with the probe. However, this known plasma probe does not provide additional information about the plasma composition and/or quality, neither about the film deposited on the probe and/or its influence on the monitoring results. Although the dielectric film deposited on the probe does not prevent the measurements in capacitively coupled Langmuir probe as in the standard Langmuir probe, the measured signal is altered and the original fitting function cannot be applied.

US2005034811 discloses a plasma diagnostic apparatus comprising dynamically pulsed dual floating Langmuir probes. The dual planar probe is not suitable to measure the absolute values of the floating and plasma potential, nor the separate electron and ion fluxes.

Therefore it is desirable to have a plasma probe that would solve at least one of the above mentioned drawbacks.

**Summary of the disclosure**

It is an aim of the present disclosure to provide a method and device for monitoring a plasma in a plasma reactor which uses simpler electronics circuitry and yet does not show the limitations of the prior art.

This aim is achieved according to the disclosure with the method and device of the independent claims.

In a first aspect, the disclosure provides a method and device (also referred to as 'DC technique' or 'DC pulsed' throughout the description) which are suitable to measure separately (and subsequently) both the ion saturation current and the electron current, for probe potentials above the floating potential. It has been found that this information can be obtained by applying suitable DC levels/pulses only on a single Langmuir probe, so that simpler electronics circuitry can be used. Furthermore, it has been found that additional information can be obtained by using DC biasing, namely capacitance and thickness of a dielectric film deposited on the Langmuir probe surface.

In an embodiment, the method and device may be applying a signal to said biasing capacitor comprising positive DC-pulses suitable for charging the biasing capacitor above a floating potential of the plasma alternating with negative DC-pulses suitable for charging the biasing capacitor below a floating potential of the plasma and wherein the measuring means is provided for measuring an electron flux from the plasma to the probe during said positive DC-pulses and an ion flux from the plasma to the probe during said negative DC-pulses. The signal is preferably symmetric relative to the floating potential of the plasma, so that information on capacitance and/or thickness of the dielectric film can be determined by subtraction of the electron flux from the ion flux.

In a second aspect, the disclosure provides a plasma reactor comprising a plurality of plasma monitoring devices using the DC-technique described herein, to gather information about the spatial distribution of at least one plasma parameter inside the chamber.

In a third aspect, the disclosure provides a method for measuring in-situ a capacitance of a dielectric film deposited on a surface of a single Langmuir probe which is located inside a chamber of a plasma reactor in contact with a plasma, the method comprising the steps of:

a) alternatingly providing the single Langmuir probe with positive and negative DC-pulses through a biasing capacitor, the positive DC-pulses being suitable for charging the biasing capacitor above a floating potential of the plasma and the negative DC-pulses being suitable for charging the biasing capacitor below a floating potential of the plasma;

b) measuring a first probe potential during the positive DC-pulses and a second probe potential during the negative DC-pulses;

c) calculating the difference ($\Delta V$) between the measured first floating potential and the measured second floating potential;

d) calculating the capacitance of the dielectric film ($C_{film}$) using the calculated difference ($\Delta V$), the amplitude of the DC-pulses (Va) and the capacitance of the biasing capacitor ($C_{bias}$).

In an embodiment, the method may further comprise the step of determining the thickness of the dielectric film using the capacitance of the dielectric film ($C_{film}$) and known physical characteristics of the dielectric film.

## Brief description of the drawings

The disclosure will be further elucidated by means of the following description and the appended figures.

Figure 1 shows schematically an experimental set up comprising a DC pulsed planar Langmuir probe according to embodiments of the disclosure.

Figure 2 shows a comparison between RF pulsing and DC-pulsing: (a) the RF and DC- pulsed signal applied (b) potentials measured at the biasing capacitor for the RF and the DC-pulsed case. The discharging current is also measured but not shown.

Figure 3 shows simulated (Wolfram Mathematica™ version 7.0) results for a DC pulsed Langmuir probe as follows. (a) Applied pulses (dashed line) and measured potential at the probe (full line). Charging the capacitor at beginning of the positive pulse by the electron pulse is marked with (1) and discharging by the ion flux is marked with (2). (b) The total current to the probe showing the ion saturation current and the electron current.

Figure 4 shows experimental measurement with a DC pulsed probe, wherein only the ion discharging part is shown: (a) potential measured at the probe (b) discharging current through the capacitor. The measurement was performed in argon plasma, with 100 nF biasing capacitor and a probe with 0.85 cm$^2$ area.

Figure 5 shows the probe current as function of the probe bias: dotted line - experimental data measured with a DC pulse, full-line theoretical fit according to equation (2) in the description.

Figure 6 shows the I-V characteristic obtained by DC pulsing applied to the probe. The dots represent ion saturation current obtained (b), while the triangles represent the electron current (a). The current is shown inverted.

Figure 7 shows limiting electron current by using a ramp DC pulse (i.e. a gradually increasing positive pulse) instead of square DC pulse. The dashed line is the applied ramp DC pulse and the thin black line the measured potential at the probe (scale on the left side). The current calculated from the potential at the capacitor is represented by the thick gray line with the scale on the right side.

Figure 8 shows schematically the setup for determining the capacitance of a dielectric film, wherein the film formed on the probe is modeled by a capacitor connected by a dashed line, $V_a$ is applied DC voltage pulse, $C_{bias}$ is the biasing capacitor, V is potential measured by an oscilloscope with internal resistance R, while $C_{film}$ and $R_{film}$ are capacitance and resistance of the film, respectively.

Figure 9 shows comparative results, the I-V characteristic for measurements with an RF plasma probe in the presence of a dielectric film (the solid line, a) and for a clean probe, i.e. without dielectric film (the dashed line, b) .

Figure 10 shows the measured potential for a DC pulsed plasma probe in the presence of a film on the probe (b- thin film of about 1 nm $SiO_2$ and c - thick film of about 5 nm $SiO_2$) and without a film (a). Although in all cases the probe surface in contact with plasma goes to the floating potential at the end of the positive and negative pulses, the measured potentials in the case of the dielectric film are not equal due the effect of a voltage divider.

Figure 11 shows a test mimicking a film capacitance by inserting an additional capacitor (with the capacitance ranging from 0.47 to 47 nF) in series with the biasing capacitor (4.7 nF). The values for the 'film' capacitance calculated from measured potentials have a good match with the real values of the additional capacitor.

Figure 12 shows the equivalent electrical circuit used for modeling the experimental setup in case the film is a 'leaky' dielectric (having a certain resistivity).

Figure 13 shows an I-V curve measured by a probe covered with a dielectric layer (silicon oxide layer on top of silicon made probe). Argon + 0.5% oxygen plasma at 120 mTorr and 800 W 27 MHz CCP.

Figure 14 shows the same as Figure 13, but with marked the region A which can be obtained with both DC and RF pulsing, and the region B which can be obtained only by DC pulsing. A hysteresis in the region B is a clear sign that the probe (and other walls including the grounded electrode) are coated with a dielectric layer.

Figure 15 shows experimental data which are the same as in Figure 13 on which approximate fitting is done by fixing the floating potential to the measured value at which the current is equal to 0 and by fixing the electron temperature to 3 eV.

Figure 16 shows a comparison of a numerical simulation and the experimental data from Figure 13. Marked regions A and B in hysteresis with arrows indicate the direction of the time the points are collected.

**Detailed description of preferred embodiments**

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

The detailed description below relates to a plasma diagnosis device and method. More specifically it relates to a DC pulsed Langmuir probe suitable to be used for plasma diagnostics in a semiconductor manufacturing tool. Plasma diagnostics is the monitoring of plasma parameter data, such as positive ions flux and/or electron flux.

The devices according to the disclosure may be arranged to measure and quantify both the positive ions flux and the electron flux from a plasma to a solid surface in contact therewith, for example a wall of a plasma reactor or a sample to be processed in the plasma reactor.

Preferably, the probe of the disclosure has a planar geometry, being herein referred further as DC pulsed planar Langmuir probe.

Preferably, the probe of the disclosure is mountable on the chamber wall (or in the grounded electrode) thereby minimizing the perturbation of the plasma. A capacitively coupled planar Langmuir probe can be made of the same material as the walls of the chamber and incorporated into the walls (or into the grounded electrode) thus further minimizing plasma perturbation.

Further the present disclosure also relates a method of monitoring and/or controlling a plasma process using the DC pulsed planar Langmuir probe of the disclosure. A plasma process can be in general a plasma process for modifying the structure or the chemical composition of a surface by ion bombardment or a plasma process for coating a sample with a layer. More specifically a plasma process can be a plasma etch process or plasma assisted/enhanced deposition process.

Furthermore the disclosure relates to a method for measuring the capacitance of an insulating film deposited on the probe of the disclosure. More specifically when the physical properties (i.e. dielectric constant) of the deposited film are known the thickness of the deposited film can be measured/monitored in-situ.

An advantage of the DC pulsed planar Langmuir probe of the disclosure is that simpler electronics circuitry may be used. Another advantage is that it may provide information about the electron density and/or the capacitance of the film deposited on the probe.

In various embodiments, the method comprises measuring at least one plasma parameter in real-time, monitoring the at least one plasma parameter as a function of time thereby identifying any variations and using the measured values to adjust/control the plasma process. Alternatively, the measurements can be stored in a database for later evaluation in relation with the sample (wafer) processed.

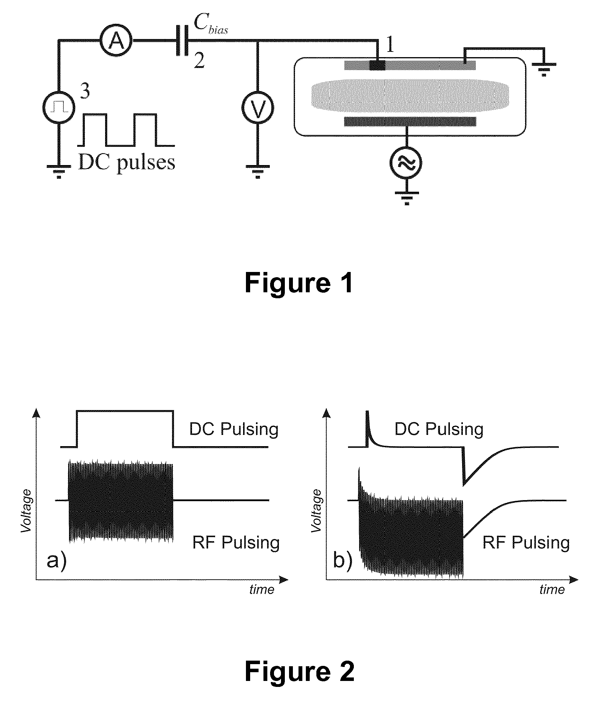

Figure 1 shows a possible experimental setup for the DC pulsed planar Langmuir probe of the disclosure comprising: a planar probe (1) mounted in the grounded electrode which is capacitively coupled through a biasing capacitor (2) to a DC pulse generator /source (3). The probe area may range between 20 mm$^2$ to 100 cm$^2$ or more, up to the area of the whole grounded electrode which can be adapted to function as a probe. In a particular example, the probe area was about 1 cm$^2$. The capacitance of the biasing capacitor may range between 100 pF and 1000 nF, or higher in the case of high density plasmas or large area probes. In a particular example, the biasing capacitor had a capacitance of 100 nF.

The measurements were conducted in a Capacitively Coupled Plasma (CCP) reactor with a probe having a planar geometry mounted in the grounded top electrode.

In one embodiment of the disclosure, the probe may be made of stainless steel and have a diameter of 5 mm. In other embodiment, the probe may be made of silicon with a diameter of 10 mm.

The DC technique of the disclosure is suitable to measure separately (and subsequently) both the ion saturation current and the electron current, for probe potentials above the floating potential.

In the examples below, square DC pulses with a period from a few hundred microseconds to 500 ms and amplitude of up to 100 V were applied.

In alternative embodiments, shaped (ramp) pulses with a ramp-up time of up to 50 ms were applied (i.e. the positive pulse was gradually increased to its maximum value during up to 50 ms). In this way, the electron current at the beginning of the positive pulse can be limited, thereby limiting the plasma perturbation and protecting the circuitry.

The DC pulsing generator (3) is arranged to produce square DC pulses of at least 20 V amplitude peak to peak with a period between 1 ms and 500 ms. However, specific values may depend on the choice of the capacitor, area of the probe, contamination of the probe (i.e. the presence of a film), ion flux (i.e. plasma density) etc.

The amplitude of the DC pulse is chosen such that the potential at the probe can repeal substantially all electrons during discharge with ions. In the case of a clean probe (no film present on the probe) the amplitude may be about 20 V, but in the case of a contaminated probe (i.e. with a film deposited on the probe) higher potential may be required due effect of voltage divider generated by additional capacitance of the film.

Duty cycle (i.e. the ratio of positive part of the pulse to the pulse period) and the period of the DC pulses are preferably chosen such that the capacitor has enough time during positive part to build up DC bias by the electron flux collected on the probe and also enough time during the negative part of the pulse (i.e. between positive pulses) to discharge.

For example, in the case of a capacitively-coupled plasma (with a plasma density of about $10^{16}$ m$^{-3}$), for a probe with an area of 1 cm$^2$ and a capacitor of 100 nF the period was about 100 ms, with the duty cycle of about 0.5.

Because of additional DC bias that is built up on the biasing capacitor and added to the applied pulses, DC pulses can be positive, negative or containing both positive and negative parts (which parts can be symmetric or asymmetric). Preferably, but not essentially, a symmetrical signal relative to the floating potential is used for measurement of the film thickness.

Comparative data including RF measurements (state of the art) and DC pulsed measurements according to embodiments of the disclosure with a pulse having a positive part and a negative part are shown in Figure 2. A clear difference can be observed during biasing the capacitor between the two regimes (i.e. during the RF pulse in the RF case or during positive part of the pulse in the DC case).

In the RF-regime, the plasma is perturbed by the RF potential during the whole pulse, while with a DC pulse the positive potential drags electrons from the plasma at the beginning of the pulse, but once the capacitor is biased and the probe is at the floating potential the plasma is not perturbed at all, irrespective of the duration of the pulse.

In the RF regime the interpretation of the signal is cumbersome due the over-imposed RF signal. When a DC-pulse is applied the interpretation is simpler and complete I-V characteristics can be obtained (containing information about both electrons and ions fluxes) even during the charging of the biasing capacitor.

During the discharging of the biasing capacitor by the ion flux (i.e. after the RF pulse is stopped in the RF case, or during the negative part of the pulse in the DC case), the behavior in both cases (RF and DC) is similar (if the capacitor is biased to the same potential) and both techniques give the same results.

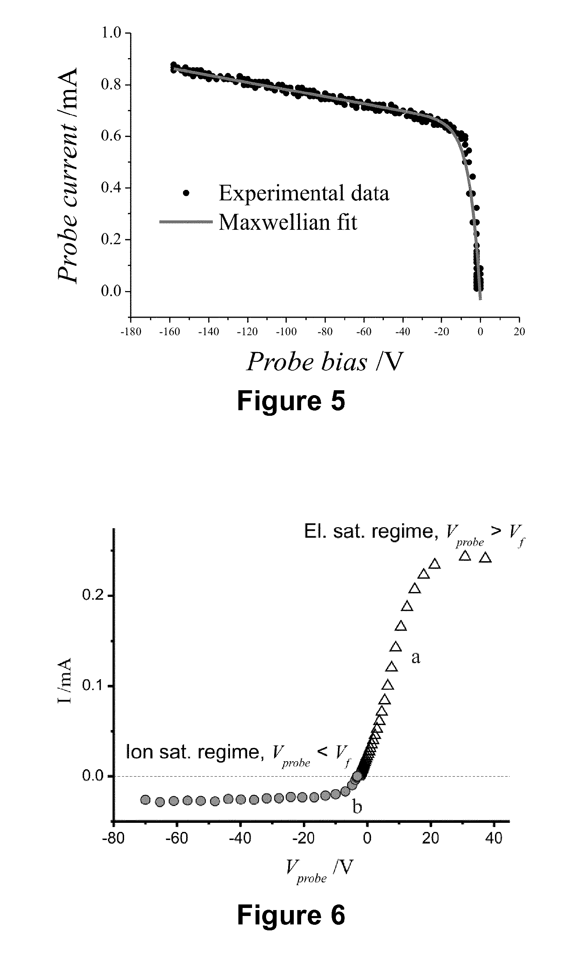

Consequently, measurements of the voltage (shown in Figure 2) and current (shown in Figure 6) during the capacitor discharge did not present any significant difference between RF and DC-pulses.

One of the advantages of the DC-pulsed probe and method of the disclosure is that the electron current determined during the positive part of the DC-pulse complements the measurement of ion current to provide the complete I-V characteristic as shown in Figure 6.

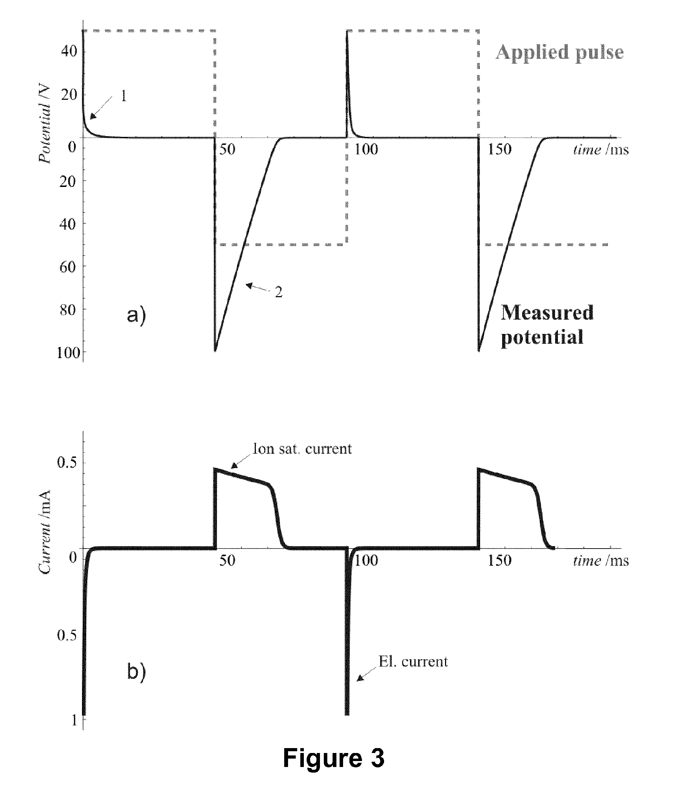

An example of the signal measured at the probe for an applied DC pulse is shown Figure 3. The applied DC pulse (the dashed line in Figure 3a) has a period of 100 ms, duty cycle 0.5 and amplitude of 50 V, i.e. positive part of the pulse is 50 V for the first 50 ms and then there is a negative part of 50 ms with the potential of -50 V.

As shown in Figure 3 the capacitor is quickly biased with the relatively high electron current at the beginning of the positive pulse. After biasing, the probe is at the floating potential and the net current (i.e. a sum of the ion and the electron current) is equal to zero. After the positive pulse, both the applied potential and the probe potential become negative and electron current is completely blocked such that the total current collected at the probe consists only of the ion current.

The total current through the circuit (i.e. biasing capacitor (2)) equals the sum of electron flux and ion flux to the probe. While the ion flux is only slightly influenced by the DC-pulse applied to the probe, the electron flux is an exponential function of the applied potential relative to the plasma potential. Because the capacitor blocks any DC current, any surplus of charge is collected at the capacitor which changes potential of the probe. The potential at the probe is equal to the difference of the applied potential and the potential at the biasing capacitor:

$$V_{probe} = V_{applied} - V_{bias} \qquad (1)$$

When the capacitor is charged to biasing potential the probe will be subjected to the floating potential at which both currents (ion and electron) are equal such that the system is in equilibrium.

The experiments show that during the first few milliseconds after the positive DC-pulse is applied, the probe potential gets positive and attracts extra electrons. These extra electrons bias the capacitor negatively and the probe reaches again the floating potential and the total current to the probe is equal to zero (the solid line in Figure 3a).

The duration of the remaining positive pulse is not important as the probe floats at the floating potential until the applied potential changes. The biasing potential is equal to $V_{bias} = (V_{applied} - V_{probe})$ and because $V_{probe} = V_{floating}$, the final value of the biasing potential at the end of the positive pulse is $V_{bias} = (V_{positive} - V_{floating})$, wherein $V_{positive}$ is the positive amplitude of the applied DC pulse.

At the moment when $V_{applied}$ changes from $V_{positive}$ to $V_{negative}$, the probe potential is still given by the equation (1) above, but $V_{bias} = (V_{positive} - V_{floating})$ and $V_{amplitude} = V_{negative}$, SO the probe potential is equal tO Vprobe = Vnegative - Vpositive + $V_{floating}$ or, in the case of the symmetric pulse, $V_{probe} = -2 V_{positive} + V_{floating}$ (as shown in Figure 3a wherein $V_{floating} = 0$).

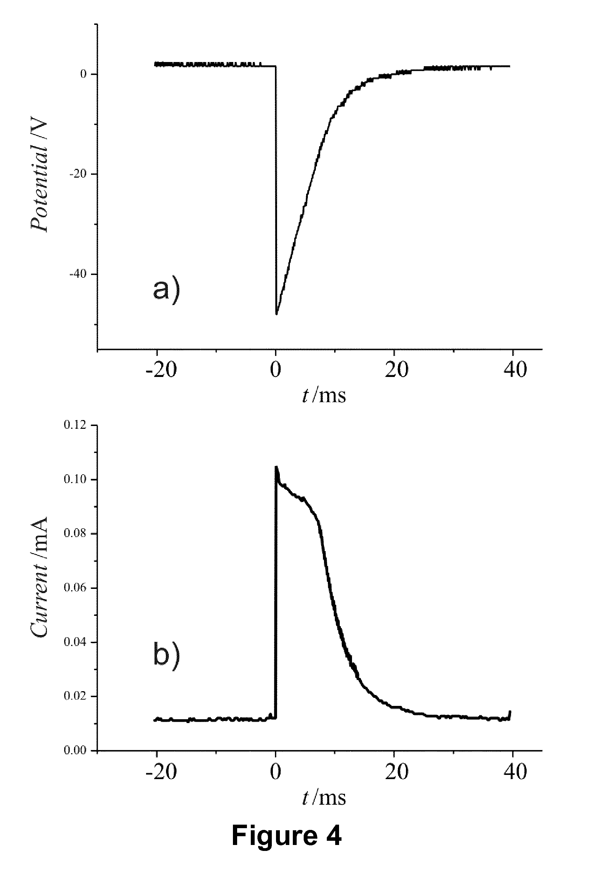

If the amplitude of the applied DC pulse is sufficient to repeal the electrons, the capacitor is discharged by the ion current (see Figure 3b and Figure 4) until it reaches biasing potential that will give the probe the floating potential. This discharging is similar with the RF case, therefore the same theoretical interpretation may be applied:

$$I = I_0 \left\{ 1 - s(V - V_f) - exp\left(\frac{V - V_f}{kT_e}\right) \right\} \qquad (2)$$

wherein $I_0$ is ion saturation current, $V_f$ floating potential, $T_e$ electron temperature and s the slope parameter (related to the edge effects).

An example of fitting equation (2) to real experimental data is shown in Figure 5. Experimental data shown in Figure 5 are obtained by DC pulsing.

In addition to these data points (i.e. ion discharging current for potentials below the floating potential, DC pulsing can also give the Langmuir I-V characteristics needed for calculation of other plasma properties (i.e. electron transition curve, electron saturation current and the plasma potential), which is shown in Figure 6.

As can be seen from Figures 3 and 6 electron current can be relatively high at the beginning of the positive pulse, but if this presents a problem for the probe electronics or the plasma perturbation, it can be limited by a gradual increase of positive potential at the beginning of the positive pulse (i.e. using a positive ramp instead of a square DC pulse). In this way the total current is limited by the rate of the increase of applied potential:

$$I_{max} = C_{bias} \frac{dV_{applied}}{dt} \qquad (3)$$

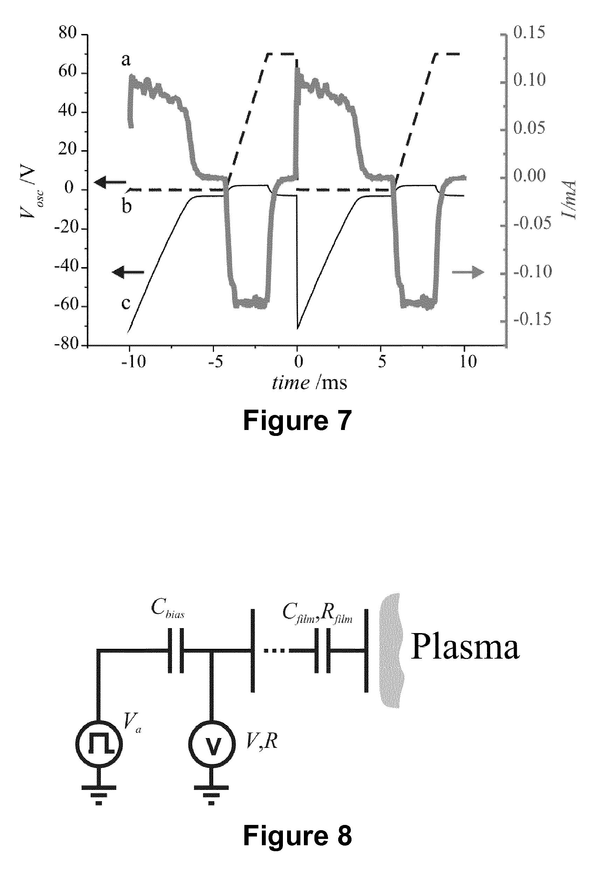

An example of measurements with a ramp DC pulse instead of the DC pulse is given in the Figure 7.

Embodiments of the disclosure describe monitoring the plasma with a dielectric film deposited on the probe. The dielectric film can be the result of the deposition/sputtering process performed in the chamber.

One of the major drawbacks of the prior art Langmuir probe measurements is that a dielectric film deposited on the probe is blocking any DC current from flowing to the probe, making the plasma monitoring not possible anymore.

This drawback can be solved by the capacitively coupled probe of the disclosure, since the dielectric film acts as an additional capacitor in series with the biasing capacitor as shown in Figure 8. The measured signal will change accordingly because the probe potential is not measured directly anymore but through a voltage divider formed by the biasing capacitor and the capacitor introduced by the dielectric film.

In embodiments of the disclosure measurements of the film capacitance were mimicked by adding an additional capacitance in series between the biasing capacitor and the probe.

In other embodiments of the disclosure, measurements with a real film over the probe (e.g. a $SiO_2$ layer deposited on top of the silicon probe) were performed.

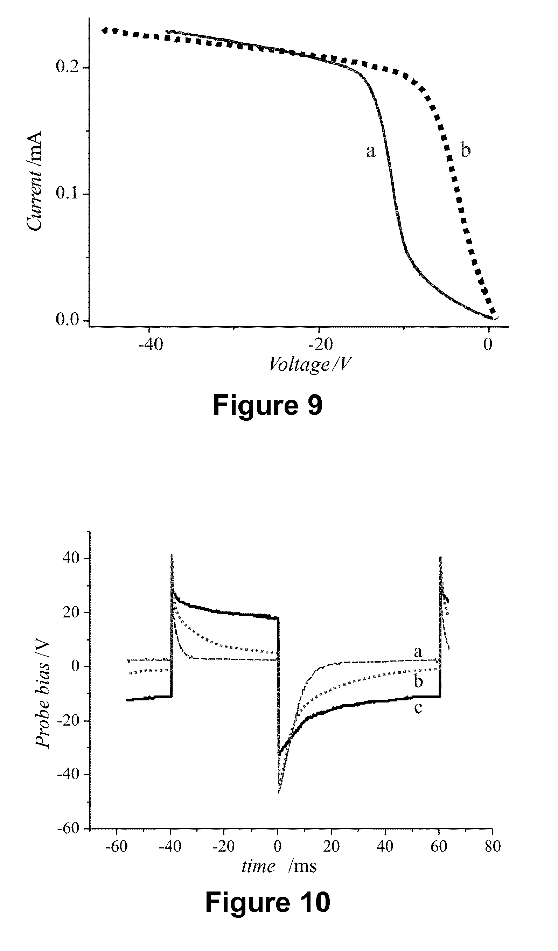

The difference between the measurements with and without the dielectric film is shown in Figure 9. Information on the ion flux is still present, but fitting equation (2) cannot be applied anymore because it was derived for the case of direct measurements of the potential on the probe and not through a potential divider formed by the biasing capacitor and the film capacitance.

The measurements shown in Figure 9 are obtained during discharging of the capacitor by the ion current, therefore they are illustrative for both RF-biasing (state of the art) and DC pulsing (method of the disclosure).

Advantageously, the method of the disclosure can provide additional information on the film properties indirectly by the measurements of the floating potential through the potential divider for the positive and the negative part of the pulse as shown in Figure 10.

Measurement of the probe potential is done through a voltage divider formed by the biasing capacitor and the film capacitance (illustrated in Figure 8). Because of that, although at the end of both parts of the pulse (i.e. the positive and the negative) the probe surface is at the floating potential, in the case of the positive pulse, a higher potential is measured, and in the case of the negative pulse, a lower potential is measured. Comparing these two values and knowing the biasing capacitance, it is possible to calculate the capacitance of the film using equation (4):

$$C_{film} = C_{bias} \frac{V_a - \Delta V}{\Delta V} \tag{4}$$

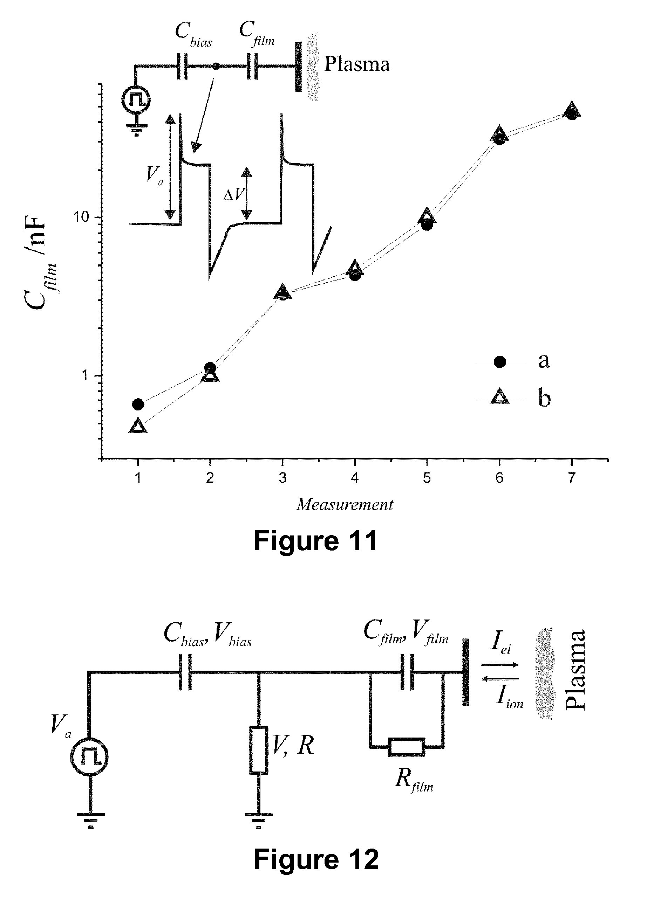

wherein $C_{film}$ is the capacitance of the film, $C_{bias}$, the capacitance of the biasing capacitor, $\Delta V$ the difference in the measured floating potentials and $V_a$ the amplitude of the DC-pulse applied. The formula (4) above was confirmed experimentally by using a clean probe (i.e. without dielectric film and capacitance) and by inserting an additional capacitor in series with the biasing capacitor that acted as a dielectric film capacitance. The results for several different capacitors are shown in Figure 11. As shown, values of the "film capacitance" calculated from the measured potential at the biasing capacitor are in good agreement with the actual value of the capacitors used.

Measurements with a real film formation shown in Figure 10 confirm sensitivity of the method of the disclosure for measurements of the film capacitance. Further if the properties of the film material are known (e.g. its dielectric constant) the film thickness can be determined. The method of the disclosure allows thus in-situ measurement and/or in-situ monitoring of the film thickness.

Advantageously, the whole grounded electrode can be used as a probe. In that case, the grounded probe should not be grounded directly but through a biased capacitor and the pulse generator. The electrode, now acting as a probe, could be grounded and only during periodical short measurements (e.g. for duration of 1 ms every 100 ms) a DC pulse would be supplied to it and measurements obtained.

In this way more accurate measurements of the total ion flux to the probe could be done with even smaller perturbation of the plasma because the electrode would remain uniform (i.e. there would be no additional probe implemented in the grounded electrode).

In the case the film is not a pure dielectric material but has a certain resistivity (a 'leaky' film), the equation (4) cannot be applied as such. Values of both the film capacitance and the film resistance can still be obtained by comparing the measured data with numerical simulations.

The measured data can be successfully compared with results of numerical simulations performed in Wolfram Mathematica 7.0, but can be performed as well with any other suitable software.

As it is already mentioned, a dielectric film on the probe acts as an additional capacitor in series with the biasing capacitor. In reality the film is not an ideal capacitor, but a better representation would be a capacitor with a resistor in parallel as it is shown in the equivalent circuit of Figure 12), which can be used for the numerical simulations. Although the additional capacitor should not have any significant effect on the ion flux, it affects the measurement of the I-V curve in two ways. First, the total capacitance of the circuit is smaller (two capacitors in series) so the charging/discharging with the same flux is faster. Also the potential is not read any more directly on the probe surface which is in contact with the plasma (and that is actually potential that determines I-V characteristic) but through a kind of voltage divider formed by the biasing capacitor ($C_{bias}$) and the film capacitance ($C_{film}$). These two capacitors are not charged/discharged with the same speed or even with the same sign during the whole pulse so the potential divider formed by them does not have a constant ratio which implies that the relation between the measured and actual potential is also not constant.

The discharging of the capacitor and the film can be represented by the following differential equations:

$$C_{bias}\frac{dV_{bias}}{dt} = -I_{ion} + I_e\left(V_a - V_{bias} - V_{film}\right) + \frac{V_a - V_{bias}}{R} \qquad (5)$$

$$C_{film}\frac{dV_{film}}{dt} = -I_{ion} + I_e\left(V_a - V_{bias} - V_{film}\right) + \frac{V_{film}}{R_{film}} \qquad (6)$$

wherein $V_a$ is the applied pulse, $V_{bias}$ is the potential at the biasing capacitor, $V_{bias}$ is the potential at the dielectric film, $I_{ion}$ ion current, $I_e$ electron current and the other variables as presented in Figure 12. The electron current is a function of the potential at the probe surface in contact with the plasma and it is given by:

$$I_{e}(V) = I_{e0}\,exp\left(-\frac{V_p - V}{kT}\right) \qquad (7)$$

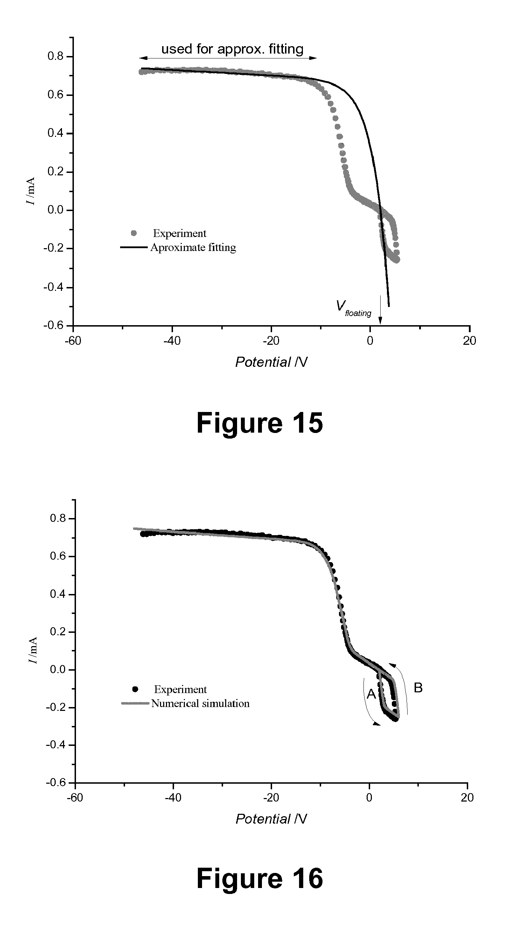

Results of simulation are shown in Figure 16. In the case of a 'leaky' film the measured data should be compared with simulations with different values of film resistance and capacitance. Final values for the real film capacitance and the resistance are given by the values used for the numerical simulation with the best matching of measured and simulated data.

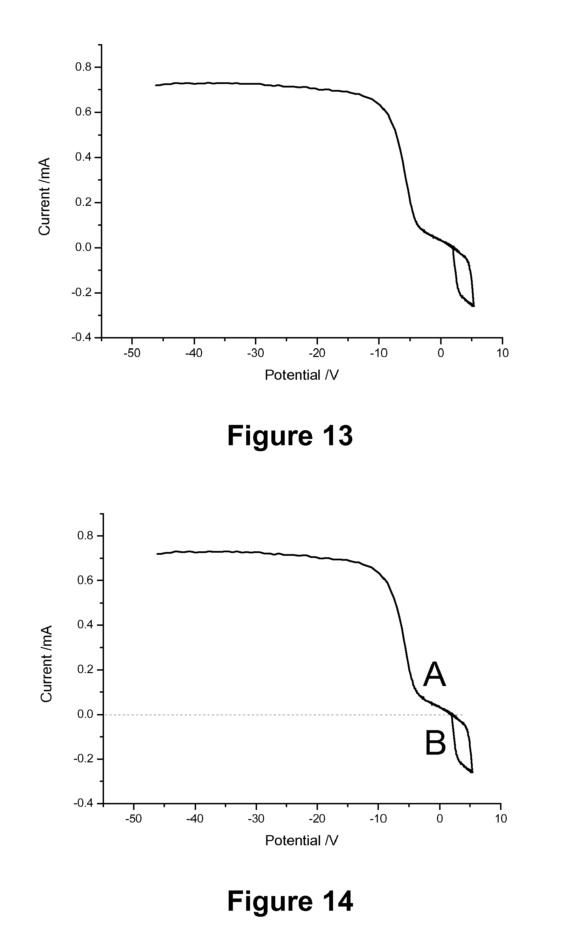

This approach is experimentally tested by comparing measurements on a setup according to Figure 1, with a film deposited on the probe, and on a setup mimicking a film by a real capacitor in parallel with a resistor (with known values of capacitance and resistivity) connected in series with a clean probe. The additional capacitor and resistor were added in series with the biasing capacitor, at the place of the Cfilm and Rfilm in Figure 12. The resulting I/V-curves are shown in figures 13-16.

Figure 13 shows an I-V curve obtained from real measurements on a probe covered with a dielectric layer (silicon oxide layer on top of silicon made probe) in Argon + 0.5% oxygen plasma at 120 mTorr and 800 W 27 MHz CCP reactor.

Figure 14 shows the same I-V curve as in Figure 13, but with marked the regions A and B. The region A can be obtained with both DC and RF pulsing, but the region B which can be obtained only by DC pulsing. A hysteresis in the region B is a clear sign that the probe (and other walls including the grounded electrode) are coated with a dielectric layer. The area of the hysteresis can be an indication of the thickness of the dielectric layer.

Figures 15 and 16 shows experimental data which are the same as in Figure 13 on which in a first step (Fig. 15) approximate fitting is done, using equation (2), by fixing the floating potential to the measured value at which the current is equal to 0 and by fixing the electron temperature to 3 eV, and on which in a second step a more accurate fitting is done, using equations (5) and (6) for different values of film resistance and capacitance and then selecting the best fit.

In general, embodiments according to this disclosure can be summarized as follows.

A method for monitoring a plasma in a plasma reactor, comprising measuring a plasma parameter data at a surface in contact with the plasma by measuring the discharge rate of a biasing capacitor connected between a DC-voltage source for applying a DC-bias and a single planar Langmuir probe in contact with the plasma.

The method of the above wherein the plasma parameter data consists of at least one of an ion flux or an electron flux.

The method of any of the above, wherein the plasma parameter data consists of both an ion flux and an electron flux separately measured.

The method of any of the above, wherein the single probe has a common ground potential with the plasma reactor.

The method of any of the above, wherein applying a DC-bias consists of periodically supplying the single probe with a DC-pulse.

The method of any of the above, wherein measuring the electron and ion flux is performed during the charging and, respectively, the discharging of the biasing capacitor.

The method of any of the above, wherein the DC-pulse is a positive pulse or a negative pulse or it comprises both a positive and a negative part.

A device for measuring a plasma parameter data in a chamber constituting a plasma reactor, comprising:

- a single Langmuir probe inside the chamber, the single probe having a planar surface
- a biasing capacitor external to the chamber mounted in series between the supplying means and the single probe ;
- means external to the chamber for periodically measuring the discharge current of the biasing capacitor and the potential at the single probe and at the biasing capacitor during its discharge, and
- means external to the chamber for periodically supplying the single probe with DC- pulses through the biasing capacitor.

A device according to the above, wherein the supplying means are comprised of a DC-source which provides the DC-pulses, the DC-pulses having a period and a duty cycle arranged such that the measurement of the discharge current and the potential at the single probe can be performed between two subsequent DC-pulses.

A device for measuring a plasma parameter data in a chamber constituting a plasma reactor comprising a plurality of single Langmuir probes arranged to function as above, thereby gathering information about the spatial distribution of the plasma parameter inside the chamber.

A method for measuring in-situ a capacitance of a dielectric film deposited in a plasma reactor on a surface in contact with plasma, using the device of the above, the method comprising the steps of

a. periodically supplying the single probe with a DC- pulse through the biasing capacitor, wherein the DC-pulse comprises both a positive and a negative part,
b. measuring the floating potential during the positive part of the DC-pulse and the floating potential during the negative part of the DC-pulse,
c. calculating the difference ($\Delta V$) between the measured floating potential during the positive part of the DC-pulse and the floating potential during the negative part of the DC-pulse,
d. calculating the capacitance of the dielectric film ($C_{film}$) using the difference ($\Delta V$) , the amplitude of the DC-pulse (Va) and the capacitance of the biasing capacitor ($C_{bias}$).

The method of the above, wherein the thickness of the dielectric film is monitored in-situ using the capacitance of the dielectric film and knowing the physical characteristics of the dielectric film.

**Claims**

1.    A method for monitoring a plasma in a chamber of a plasma reactor, comprising measuring plasma parameter data at a surface of a single planar Langmuir probe in contact with the plasma, comprising the steps of biasing a biasing capacitor connected between the single planar Langmuir probe and a bias source adapted to apply said biasing, and subsequently measuring a discharge current of the biasing capacitor as a result of said biasing, and a probe potential at the single probe during the discharge, **characterised in that** the biasing comprises applying a DC-bias.

2.    The method of claim 1, wherein the biasing comprises applying at least once a positive DC voltage level suitable for charging the biasing capacitor above a floating potential of the plasma and the measured plasma parameter data comprises at least one of an electron flux from the plasma to the probe and an ion flux from the plasma to the probe .

3.    The method of claim 1 or 2, wherein the biasing comprises applying at least once a negative DC voltage level suitable for charging the biasing capacitor below a floating potential of the plasma and the measured plasma parameter data comprises at least one of an electron flux from the plasma to the probe and an ion flux from the plasma to the probe.

4.    The method of claim 1, wherein the biasing comprises applying a signal comprising positive DC-pulses suitable for charging the biasing capacitor above a floating potential of the plasma alternating with negative DC-pulses suitable for charging the biasing capacitor below a floating potential of the plasma and wherein the measured plasma parameter data comprises an electron flux from the plasma to the probe during said positive DC-pulses and an ion flux from the plasma to the probe during said negative DC-pulses.

5.    The method of claim 4, wherein the signal is symmetrical relative to the floating potential.

6.    The method of claim 4 or 5, wherein the positive, resp. negative DC-pulses have a predefined period and a duty cycle arranged such that the measurement of the discharge current and the potential at the single probe can be performed between two subsequent positive, resp. negative DC-pulses.

7. The method of any one of the preceding claims, wherein the DC-bias has a positive ramp to limit electron current from the plasma to the probe at the beginning of said biasing.

8. The method of any one of the preceding claims, further comprising the step of fitting a measured I-V-curve on a simulated I-V-curve to determine presence or thickness of a dielectric film on the probe surface.

9. A device for monitoring a plasma in a chamber of a plasma reactor, comprising:

   - a single planar Langmuir probe inside the chamber having a surface for entering in contact with the plasma;
   - a biasing capacitor external to the chamber mounted in series between the single Langmuir probe and a bias source for biasing the biasing capacitor;
   - means for measuring a discharge current of the biasing capacitor as a result of said biasing, and a probe potential at the single probe during the discharge;
   **characterised in that** the bias source is a DC-bias source adapted for applying a DC-bias.

10. The device of claim 9, wherein the DC-bias source is adapted for applying at least once a positive DC voltage level suitable for charging the biasing capacitor above a floating potential of the plasma and wherein the measuring means is provided for measuring at least one of an electron flux from the plasma to the probe and an ion flux from the plasma to the probe.

11. The device of claim 9 or 10, wherein the DC-bias source is adapted for applying at least once a negative DC voltage level suitable for charging the biasing capacitor below a floating potential of the plasma and wherein the measuring means is provided for measuring at least one of an electron flux from the plasma to the probe and an ion flux from the plasma to the probe.

12. The device of claim 11, wherein the DC-bias source is adapted for applying a signal to said biasing capacitor comprising positive DC-pulses suitable for charging the biasing capacitor above a floating potential of the plasma alternating with negative DC-pulses suitable for charging the biasing capacitor below a floating potential of the plasma and wherein the measuring means is provided for measuring an electron flux from the plasma to the probe during said positive DC-pulses and an ion flux from the plasma to the probe during said negative DC-pulses.

13. A plasma reactor comprising a plurality of plasma monitoring devices according to any one of the claims 9-12 to gather information about the spatial distribution of at least one plasma parameter inside the chamber.

14. A method for measuring in-situ a capacitance of a dielectric film deposited on a surface of a single Langmuir probe which is located inside a chamber of a plasma reactor in contact with a plasma, the method comprising the steps of:

   a) alternatingly providing the single Langmuir probe with positive and negative DC-pulses through a biasing capacitor, the positive DC-pulses being suitable for charging the biasing capacitor above a floating potential of the plasma and the negative DC-pulses being suitable for charging the biasing capacitor below a floating potential of the plasma;
   b) measuring a first probe potential during the positive DC-pulses and a second probe potential during the negative DC-pulses;
   c) calculating the difference ($\Delta V$) between the measured first floating potential and the measured second floating potential;
   d) calculating the capacitance of the dielectric film ($C_{film}$) using the calculated difference ($\Delta V$), the amplitude of the DC-pulses (Va) and the capacitance of the biasing capacitor ($C_{bias}$).

15. The method of claim 14, further comprising the step of determining the thickness of the dielectric film using the capacitance of the dielectric film ($C_{film}$) and known physical characteristics of the dielectric film.

# Figure 1

# Figure 2

Figure 3

**Figure 4**

**Figure 5**

**Figure 6**

Figure 7

Figure 8

**Figure 9**

**Figure 10**

**Figure 11**

**Figure 12**

**Figure 13**

**Figure 14**

**Figure 15**

**Figure 16**

Europäisches
Patentamt

European
Patent Office

Office européen
des brevets

# EUROPEAN SEARCH REPORT

Application Number

EP 12 16 6974

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PETCU M ET AL: "A capacitive probe with shaped probe bias for ion flux measurements in depositing plasmas", REVIEW OF SCIENTIFIC INSTRUMENTS, AIP, MELVILLE, NY, US, vol. 79, no. 11, 11 November 2008 (2008-11-11), pages 115104-115104, XP012114932, ISSN: 0034-6748, DOI: 10.1063/1.3020709 * figures 1a, 1c * * page 1, column 1, line 1 - line 22 * * page 2, column 1, line 1 - line 4 * * page 2, column 2, line 21 - line 26 * * page 3, column 1, line 10 - line 43 * ----- | 1-13 | INV. H01J37/32 G01R19/00 H05H1/00 |
| A,D | US 5 936 413 A (BOOTH JEAN-PAUL [FR] ET AL) 10 August 1999 (1999-08-10) * figure 3 * * column 4, line 23 - column 6, line 8 * ----- | 1-15 | |
| A | DE 42 00 636 A1 (FRAUNHOFER GES FORSCHUNG [DE]) 15 July 1993 (1993-07-15) * the whole document * ----- | 1-15 | TECHNICAL FIELDS SEARCHED (IPC) |
| A | ST J BRAITHWAITE N ET AL: "A novel electrostatic probe method for ion flux measurements", PLASMA SOURCES SCIENCE AND TECHNOLOGY, INSTITUTE OF PHYSICS PUBLISHING, BRISTOL, GB, vol. 5, no. 4, 1 November 1996 (1996-11-01), pages 677-684, XP020070186, ISSN: 0963-0252, DOI: 10.1088/0963-0252/5/4/009 * the whole document * ----- | 1-15 | H01J G01R H05H |

-/--

The present search report has been drawn up for all claims

| Place of search | Date of completion of the search | Examiner |
|---|---|---|
| The Hague | 30 August 2012 | Hochstrasser, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**EUROPEAN SEARCH REPORT**

Application Number

EP 12 16 6974

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WANG S-B ET AL: "Control of ion energy distribution at substrates during plasma processing", JOURNAL OF APPLIED PHYSICS, AMERICAN INSTITUTE OF PHYSICS. NEW YORK, US, vol. 88, no. 2, 15 July 2000 (2000-07-15), pages 643-646, XP012051184, ISSN: 0021-8979, DOI: 10.1063/1.373715 * the whole document * ----- | 1-15 | |

TECHNICAL FIELDS SEARCHED (IPC)

The present search report has been drawn up for all claims

| Place of search | Date of completion of the search | Examiner |
|---|---|---|
| The Hague | 30 August 2012 | Hochstrasser, M |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 12 16 6974

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2012

| Patent document cited in search report | | Publication date | Patent family member(s) | | Publication date |
|---|---|---|---|---|---|
| US 5936413 | A | 10-08-1999 | DE | 69605643 D1 | 20-01-2000 |
| | | | DE | 69605643 T2 | 06-04-2000 |
| | | | EP | 0792571 A1 | 03-09-1997 |
| | | | FR | 2738984 A1 | 21-03-1997 |
| | | | JP | 3937453 B2 | 27-06-2007 |
| | | | JP | H10509557 A | 14-09-1998 |
| | | | US | 5936413 A | 10-08-1999 |
| | | | WO | 9711587 A1 | 27-03-1997 |
| DE 4200636 | A1 | 15-07-1993 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5936413 A
- US 2005034811 A